# FASCICULE DE BREVET EUROPEEN

(11) **EP 2 798 710 B1**
(45) Date de publication et mention de la délivrance du brevet: **24.02.2016**
(21) Numéro de dépôt: 12808298.9
(22) Date de dépôt: 10.12.2012
(51) Int. Cl.: H01S 3/16, H01S 3/23, H01S 3/10, H01S 3/00, G02F 1/355, G02F 1/00, G02F 1/39

(54) **SOURCE LASER A PUISSANCE CRETE SUPERIEURE A 100 TERAWATT ET HAUT CONTRASTE**
LASERQUELLE MIT SPITZENLEISTUNG VON MEHR ALS 100 TERAWATT UND HOHEM KONTRAST
LASER SOURCE HAVING A PEAK POWER OF MORE THAN 100 TERAWATTS AND HIGH CONTRAST

(30) Priorité: 30.12.2011 FR 1104151
(43) Date de publication de la demande: 05.11.2014
(73) Titulaire: THALES, 92200 Neuilly-sur-Seine (FR)
(72) Inventeur: SIMON-BOISSON, Christophe, F-92100 Boulogne-billancourt (FR)
(74) Mandataire: Henriot, Marie-Pierre
(86) Numéro de dépôt international: PCT/EP2012/074890
(87) Numéro de publication internationale: WO 2013/098058

(56) Documents cités:
- EP-A1- 1 662 306
- FR-A1- 2 930 851
- L. P. RAMIREZ ET AL: "Efficient cross polarized wave generation for compact, energy-scalable, ultrashort laser sources", OPTICS EXPRESS, vol. 19, no. 1, 3 janvier 2011 (2011-01-03), page 93, XP055039423, ISSN: 1094-4087, DOI: 10.1364/OE.19.000093 cité dans la demande
- AURÉLIE JULLIEN ET AL: "10^-10 temporal contrast for femtosecond ultraintense lasers by cross-polarized wave generation", OPTICS LETTERS, vol. 30, no. 8, 15 avril 2005 (2005-04-15) , page 920, XP055039640, ISSN: 0146-9592, DOI: 10.1364/OL.30.000920
- ZHAO-HUA WANG ET AL: "Optimization of contrast ratio and focusable intensity in 700TW femtosecond Ti:sapphire laser facility", JOURNAL OF PHYSICS: CONFERENCE SERIES, INSTITUTE OF PHYSICS PUBLISHING, BRISTOL, GB, vol. 244, no. 3, 16 septembre 2010 (2010-09-16), page 32012, XP020196574, ISSN: 1742-6596, DOI: 10.1088/1742-6596/244/3/032012
- A. JULLIEN ET AL: "High-fidelity front-end for high-power, high temporal quality few-cycle lasers", APPLIED PHYSICS B: LASERS AND OPTICS, vol. 102, no. 4, 1 mars 2011 (2011-03-01), pages 769-774, XP055039796, ISSN: 0946-2171, DOI: 10.1007/s00340-010-4201-9
- JULIA M MIKHAILOVA ET AL: "Ultra-high-contrast few-cycle pulses for multipetawatt-class laser technology", OPTICS LETTERS, OSA, OPTICAL SOCIETY OF AMERICA, WASHINGTON, DC, US, vol. 36, no. 16, 15 août 2011 (2011-08-15) , pages 3145-3147, XP001564847, ISSN: 0146-9592, DOI: 10.1364/OL.36.003145 [extrait le 2011-08-10]
- ANTONUCCI L ET AL: "14-fs high temporal quality injector for ultra-high intensity laser", OPTICS COMMUNICATIONS, NORTH-HOLLAND PUBLISHING CO. AMSTERDAM, NL, vol. 282, no. 7, 1 avril 2009 (2009-04-01) , pages 1374-1379, XP025995690, ISSN: 0030-4018, DOI: 10.1016/J.OPTCOM.2008.12.031 [extrait le 2009-01-03]
- CSABA TOTH ET AL: "Contrast Enhancement of the LOASIS CPA Laser and Effects on Electron Beam Performance of LWFA", AIP CONFERENCE PROCEEDINGS, 1 janvier 2009 (2009-01-01), pages 270-275, XP055040415, DOI: 10.1063/1.3080917
- RAMIREZ L P ET AL: "High efficient XPW generation for high contrast high energy ultrashort laser pulses", LASERS AND ELECTRO-OPTICS EUROPE (CLEO EUROPE/EQEC), 2011 CONFERENCE ON AND 12TH EUROPEAN QUANTUM ELECTRONICS CONFERENCE, IEEE, 22 mai 2011 (2011-05-22), page 1, XP031954702, DOI: 10.1109/CLEOE.2011.5942812 ISBN: 978-1-4577-0533-5
- COTEL A ET AL: "Nonlinear temporal pulse cleaning of a 1-[mu]m optical parametric chirped-pulse amplification system", APPLIED PHYSICS B ; LASERS AND OPTICS, SPRINGER, BERLIN, DE, vol. 83, no. 1, 1 avril 2006 (2006-04-01), pages 7-10, XP019337731, ISSN: 1432-0649, DOI: 10.1007/S00340-006-2143-Z

## Description

Le domaine de l'invention est celui des lasers à impulsions de très haute puissance crête, d'au moins 100 Térawatt jusqu'à quelques dizaines de PetaWatt et même davantage. A ce niveau de puissance crête, les impulsions sont généralement ultra-courtes c'est-à-dire de durée inférieure à 200 femtosecondes .

De telles sources laser sont en particulier utilisées pour les interactions laser-matière consistant par exemple à accélérer des particules (protons, électrons, ions) ou à générer des rayonnements secondaires dans le domaine de l'UV lointain, des rayons X ou γ. Les impulsions sont focalisées sur une cible généralement solide en vue par exemple de créer un plasma à la surface de celle-ci.

Ces sources lasers à très haute puissance crête sont basées essentiellement sur les technologies de sources laser à l'état solide et le principe de l'amplification à dérive de fréquence, qu'il s'agisse d'amplification par effet laser, ou « CPA » acronyme de l'expression anglo-saxonne Chirped Pulse Amplification, ou d'amplification par effet d'optique non linéaire comme l'amplification de la fluorescence paramétrique ou «OPCPA » acronyme de l'expression anglo-saxonne Optical Parametric Chirped Pulse Amplification.

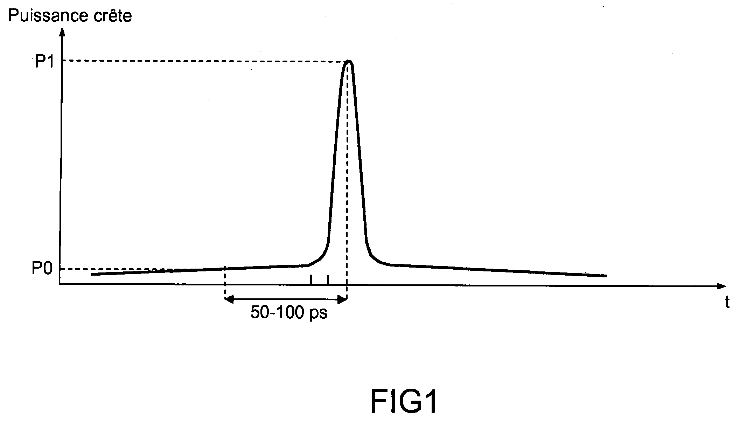

Dès lors que l'on travaille avec des lasers de très forte puissance crête, il faut prêter une très grande attention à la problématique du contraste temporel des impulsions. En effet, compte-tenu des configurations à amplificateurs multiples de ces sources laser de haute puissance crête, il subsiste toujours un résidu lumineux généré par l'amplification de l'émission spontanée (ou « ASE ») dans le cas de l'amplification laser (CPA) ou par l'amplification de la fluorescence paramétrique dans le cas de l'amplification paramétrique (OPCPA). Ce signal parasite montré figure 1, a une largeur temporelle beaucoup plus élevée que l'impulsion principale ; typiquement il existe durant les impulsions de pompage qui ont en général des durées d'impulsions d'environ quelques nanosecondes. Et surtout il est déjà présent avant l'impulsion principale. Le contraste temporel est le rapport entre la puissance crête P1 de l'impulsion principale et la puissance crête P0 de l'impulsion ASE ; les valeurs cibles et les mesures pour P0 se situent en général dans une plage temporelle entre 50 et 100 picosecondes avant l'impulsion principale de manière à s'affranchir d'autres effets comme une compression imparfaite. Le problème est que même si le rapport est très élevé, dans le cas d'une impulsion principale de très grande puissance crête, l'impulsion ASE aura quand même une puissance crête significative. Si on considère le cas d'une impulsion principale de 1 PetaWatt avec un contraste temporel de 10⁹ :1 (P1/P0 = 10⁹), l'ASE aura une puissance crête de 1 MegaWatt, suffisante en cas de focalisation sur une cible, pour créer un plasma sur celle-ci (notamment si elle est solide) avant l'arrivée de l'impulsion principale ce qui est désastreux pour les applications prévues.

Il faut donc optimiser le contraste temporel des impulsions, sachant que pour obtenir des résultats satisfaisants avec n'importe quel matériau solide constituant la cible, il faut viser des contrastes temporels par rapport à l'ASE de l'ordre de 10¹² :1 pour un laser de 1 PetaWatt et de 10¹³ :1 pour un laser de 10 PetaWatt.

Jusqu'à présent, les technologies utilisées pour augmenter le contraste temporel sont :
- l'ajout d'un absorbant saturable, ou
- la mise en oeuvre d'un filtre non linéaire basé sur la technologie de génération d'une onde à polarisation croisée dans un cristal non-linéaire, désigné par la suite filtre « XPW » pour Crossed Polarized Wave, ou
- l'utilisation de miroirs plasmas.

L'absorbant saturable est très simple de mise en oeuvre mais son apport est limité car il ne permet pas d'améliorer le contraste des impulsions de plus d'un ou deux ordres de grandeur. Ceci vient principalement du fait que les seuils d'endommagement laser de ces matériaux sont relativement faibles.

La technique des filtres XPW a été démontrée pour la première fois dans une chaîne laser de forte puissance crête en 2004. L'architecture d'un filtre XPW est relativement simple mais l'efficacité n'est pas très élevée (on obtient en sortie un maximum 30% de l'énergie de l'impulsion en entrée) et l'augmentation théorique du contraste (contraste de sortie = cube du contraste d'entrée) est fortement limitée par les taux d'extinction des polariseurs utilisés, ce qui fait que le gain net n'est que de 4 à 5 ordres de grandeur, ce qui est tout de même nettement mieux que l'absorbant saturable. Un filtre XPW comporte deux polariseurs et un ou deux cristaux non linéaires entre les deux.

La technologie des miroirs plasmas est utilisée depuis quelques années pour améliorer le contraste des chaînes laser de forte puissance crête. Le principe est basé sur l'utilisation du faisceau en sortie de chaîne, donc après la compression temporelle finale. Le faisceau est focalisé sur un milieu transparent ; l'impulsion ASE est donc transmise mais dès le début de l'impulsion principale il y a suffisamment d'intensité pour créer un plasma à la surface du matériau transparent. Ce plasma est réfléchissant, formant ainsi un miroir plasma, et il va réfléchir environ 70% de l'impulsion principale qui sera « débarrassée » d'une grande partie de l'impulsion ASE qui aura été transmise avant la création du plasma. Néanmoins, il faut répéter une deuxième fois l'opération pour obtenir une augmentation du contraste d'environ 4 à 5 ordres de grandeur. Cette impulsion principale réfléchie deux fois est alors focalisée sur la cible.

Cette technologie présente plusieurs inconvénients. La perte en énergie est donc de l'ordre de 50% et elle est définitive puisqu'il n'y a plus d'amplificateurs par la suite contrairement au cas des filtres XPW. Par ailleurs cette technologie est d'une mise en oeuvre relativement complexe. Premièrement l'ensemble du dispositif est sous vide puisqu'il s'agit du faisceau compressé et l'ensemble est assez encombrant compte-tenu de la taille du faisceau. Deuxièmement, il faut évidemment après chaque tir déplacer les miroirs plasmas puisque le spot du laser focalisé a produit un plasma hautement réfléchissant mais aussi localement un endommagement irréversible de la surface optique. Cela implique donc de mettre en place des motorisations précises et compatibles du vide.

Pour l'obtention de contrastes temporels de l'ordre de 10¹¹ :1 voire de 10¹² :1 pour une cible solide, au minimum quelques dizaines de picosecondes avant l'impulsion principale, aucune de ces techniques considérées isolément n'est suffisante et il sera donc nécessaire de les associer. De fait, compte-tenu de l'apport relativement modeste de la technologie absorbant saturable à l'amélioration du contraste, une combinaison de l'absorbant saturable avec une des deux autres techniques ne peut suffire dans la mesure où le contraste « naturel » en début de chaîne laser avant l'utilisation de ces dispositifs est de l'ordre de 10⁵ à 10⁶ :1. Il est donc nécessaire d'associer un filtre XPW et un double miroir plasma, pour obtenir le niveau de contraste requis, sachant que ce dernier dispositif présente les inconvénients pré-cités.

En conséquence, il demeure à ce jour un besoin pour un système donnant simultanément satisfaction à l'ensemble des exigences précitées, en termes de puissance crête, de contraste temporel, d'énergie, et de simplicité de mise en oeuvre.

L'idée de base de l'invention est d'associer au moins deux filtres XPW afin d'améliorer le contraste de 7 à 8 ordres de grandeur avec un dispositif extrêmement simple, de faible coût et entièrement passif c'est-à-dire sans pièces à déplacer ni à remplacer. Une compensation de la dispersion introduite par le 1er filtre XPW c'est-à-dire par la traversée des cristaux non linéaires et des polariseurs, est réalisée au moyen d'un compresseur intermédiaire de manière à produire une impulsion aux caractéristiques optimisées (durée et phase spectrale) en entrée du 2^{ème} filtre XPW.

Plus précisément l'invention a pour objet une source laser apte à émettre des impulsions d'énergie supérieure ou égale à 100 TéraWatt, constituée d'une chaîne laser qui comprend en cascade :
- un oscillateur laser à état solide,
- un premier et un dernier étage d'amplification à dérive de fréquence comportant chacun en cascade, un étireur, une chaîne amplificatrice et un compresseur,
- un premier filtre à un cristal ou deux cristaux non linéaire(s) et à susceptibilité optique non linéaire du 3è ordre, apte à générer une onde à polarisation croisée, désigné filtre non linéaire à polarisation croisée, inséré entre ces deux étages d'amplification.

Elle est principalement caractérisée en ce que la chaîne laser comprend entre le premier et le dernier étage d'amplification, au moins un autre filtre non linéaire à polarisation croisée, soit N filtres dans la chaîne laser avec N≥ 2 et N-1 compensateur(s) de dispersion, (respectivement) placé(s) en sortie du (ou des) premier(s) filtres.

Elle comprend éventuellement un troisième étage d'amplification à dérive de fréquence inséré entre deux filtres non linéaires à polarisation croisée, ce troisième étage d'amplification comportant en cascade un étireur, une chaîne amplificatrice et un compresseur, ce compresseur étant aussi un compensateur de dispersion.

Un compensateur de dispersion peut être un compresseur à miroirs à dispersion contrôlée.

Un étage d'amplification est typiquement un amplificateur CPA ou un OPCPA.

D'autres caractéristiques et avantages de l'invention apparaîtront à la lecture de la description détaillée qui suit, faite à titre d'exemple non limitatif et en référence aux dessins annexés dans lesquels :
la figure 1 montre schématiquement la puissance crête d'une impulsion principale et de l'ASE, en fonction du temps,
la figure 2 représente schématiquement un premier exemple de source laser selon un premier mode de réalisation de l'invention,
la figure 3 représente schématiquement un deuxième exemple de source laser selon l'invention.

L'idée de base de la solution proposée est d'associer au moins 2 filtres XPW afin d'améliorer le contraste des impulsions de 7 à 8 ordres de grandeur.

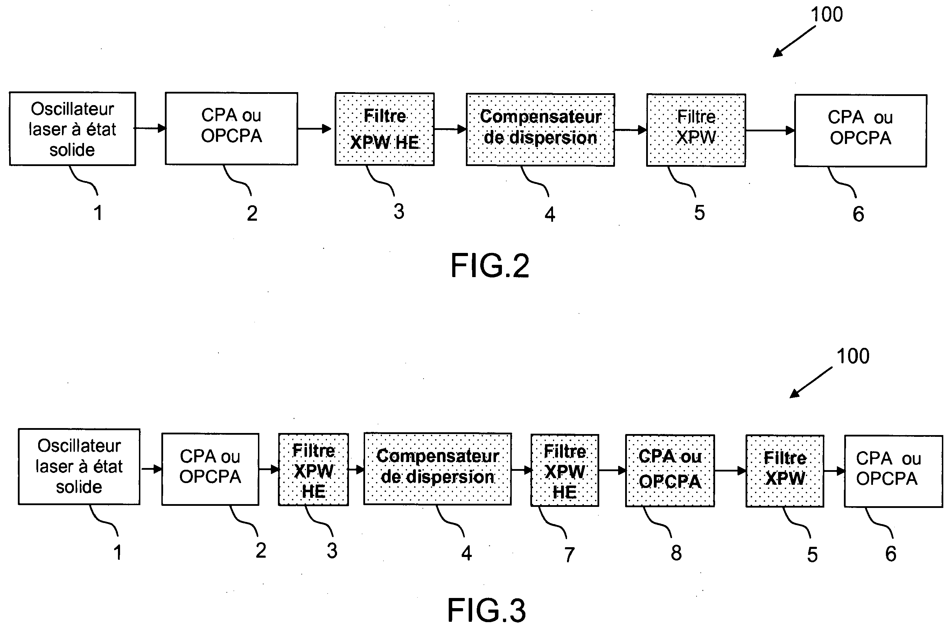

Plus précisément la source laser 100 selon l'invention dont un exemple est montré figure 2, comprend en cascade dans une configuration de base :
- un oscillateur 1 laser à état solide,
- un premier étage d'amplification 2 à dérive de fréquence CPA ou OPCPA, en sortie duquel le contraste est de l'ordre de 10⁵ ou 10⁶,
- un premier filtre XPW 3, de préférence un filtre XPW HE,
- un compensateur de dispersion 4 comportant par exemple une paire de miroirs à dispersion contrôlée,
- un autre filtre XPW 5,
- un dernier étage d'amplification 6 à dérive de fréquence CPA ou OPCPA, en sortie duquel le contraste est de l'ordre de 10¹² ou 10¹³.

On rappelle qu'un amplificateur à dérive de fréquence comporte en cascade un étireur, une chaîne amplificatrice à un ou plusieurs amplificateurs, et un compresseur. Dans chaque amplificateur, il y a un ou plusieurs passages du faisceau laser.

Un filtre XPW comporte un cristal ou deux cristaux non linéaire(s) et à susceptibilité optique non linéaire du 3è ordre et deux polariseurs. Parmi les filtres XPW utilisés dans le cadre de cette invention, on peut citer les filtres décrits dans le brevet 1 662 306. Il s'agit par exemple du filtre XPW comprenant un premier polariseur P1 qui permet d'obtenir à partir de l'impulsion en entrée du filtre, un champ E polarisé rectilignement. Ce champ est focalisé sur un cristal C cubique c'est-à-dire ne présentant pas d'écart de vitesse de groupe entre le champ incident et le champ généré, tel qu'un cristal BaF₂ qui est en outre transparent sur une large gamme spectrale, de l'ultraviolet à l'infra-rouge. Le champ E peut être focalisé en dehors du cristal C mais près de celui-ci. Ce cristal C convertit une partie du champ incident en un champ E'1 à polarisation rectiligne, orthogonale à celle de E. Une autre partie du champ incident est transmise par le cristal C sans être converti : ce champ non converti, de même polarisation que le champ incident est porteur de l'ASE.

Selon un premier mode de réalisation, le filtre comporte un deuxième cristal à géométrie cubique apte à recevoir en entrée le champ E'1 et le champ E résiduel et à générer à partir de ce champ E résiduel un champ E'2 de même polarisation que E'1 et ayant les mêmes propriétés temporelles, et donc capable de produire des interférences constructives avec le champ E'1.

Selon un autre mode de réalisation, le cristal C suffit à générer ce champ E'2 dans une configuration multipassages.

Un deuxième polariseur P2 à polarisation rectiligne orthogonale à celle de P1, permet d'atténuer voire de supprimer le champ porteur de l'ASE, pour ne laisser passer que le champ E'1+ E'2 c'est-à-dire celui de l'impulsion principale.

Comme indiqué précédemment, le premier de ces filtres 3 est de préférence un filtre XPW HE (Haute Energie), ainsi dénommé car il est apte à recevoir des impulsions dont l'énergie d'entrée se situe entre 0.5 mJ et 15 mJ, grâce à une configuration telle que la dimension du faisceau sur le (ou les) cristal (cristaux) est compatible de ce niveau d'énergie. Un exemple d'une telle configuration est décrit dans « Efficient cross polarized wave generation for compact, energy-scalable, ultrashort laser sources », Ramirez & al., Optics Express, Vol. 19, Issue 1, pp. 93-98 (2011). Le second filtre 5 est un filtre XPW HE ou un filtre XPW conventionnel tel que décrit ci-dessus, dont l'énergie d'entrée se situe entre 0.1 et 0.5 mJ.

Dans la mesure où le premier filtre 3 introduit de la dispersion induite par la propagation du faisceau à travers les polariseurs et le(s) cristal(aux) non-linéaire(s) où se produit l'effet XPW, il est impératif de compenser cette dispersion de manière à présenter un faisceau aux caractéristiques optimales sur le 2ème (autre) filtre XPW 5. Compte-tenu de la valeur relativement faible de cette dispersion, la compensation est réalisée au moyen d'un compresseur 4 à miroirs à dispersion contrôlée (une paire de miroirs en général), qui sont des composants disponibles commercialement de manière courante et dont les caractéristiques de dispersion peuvent être ajustées en fonction de la compensation à produire.

Il peut y avoir un compensateur de dispersion après le second filtre XPW 5, mais pas nécessairement dans la mesure où le faisceau est étiré immédiatement après et où la compensation peut être réalisée au moyen des réglages du compresseur du dernier étage d'amplification 6 à dérive de fréquence.

Il existe des filtres XPW qui en termes d'énergie admissible à l'entrée (jusqu'à 15 mJ), rendent une telle combinaison possible : en effet, si par exemple le premier filtre XPW reçoit une énergie de 3 mJ et a une efficacité de 15%, il produit un faisceau de 450 µJ qui compte-tenu des pertes, notamment celles du compresseur dont les miroirs sont à dispersion contrôlée, permet de disposer de 300 µJ à l'entrée du 2ème filtre XPW. Lorsque ce 2ème filtre a une efficacité de 20%, il permet de délivrer une énergie de 60 µJ pour l'injection du deuxième étage d'amplification à dérive de fréquence, soit une valeur tout à fait suffisante et largement au niveau de l'état de l'art actuel.

On résout ainsi le problème de la complexité, car les étages XPW sont très simples, se composant de quelques cristaux et quelques composants optiques dont les dimensions restent modestes car les énergies en jeu sont faibles à cet endroit de la chaîne.

Le premier filtre 3 est éventuellement placé sous vide compte-tenu de l'énergie incidente mais il s'agit d'une enceinte à vide ne comportant que le (ou les) cristal (aux) non-linéaire(s) et un dispositif de filtrage spatial soit typiquement un cylindre de diamètre 5 cm et de longueur 50 cm, et donc une enceinte beaucoup moins volumineuse que dans le cas des miroirs plasmas de l'ordre d'un m³ ; par ailleurs le niveau de vide requis est bien moindre que dans le cas des miroirs plasmas (de l'ordre de 2 ordres de grandeur de moins).

Le deuxième problème induit par le double miroir plasma, celui de la perte en énergie, est là encore résolu car les filtres XPW étant placés en début de chaîne laser, il suffit pour compenser la perte importante qu'ils introduisent (la transmission totale n'est que de quelques %), d'ajouter un ou deux passages dès le premier amplificateur multi-passages du deuxième étage d'amplification à dérive de fréquence.

Un moyen préféré de réalisation consiste en l'architecture suivante utilisant la configuration de base, avec en cascade :
- un oscillateur 1 Saphir Titane à verrouillage de modes,
- un premier CPA 2 Saphir Titane délivrant typiquement 3 mJ, en sortie duquel le contraste est de l'ordre de 10⁵ ou 10⁶,
- un filtre 3 XPW HE à 1 cristal de BaF2 de rendement 15% par exemple,
- un compensateur de dispersion 4 muni d'une paire de miroirs à dispersion contrôlée, de transmission globale de l'ordre de 70%,
- un filtre 5 XPW à 2 cristaux de BaF2 de rendement 20%, avec une énergie d'entrée typique de 300 µJ et une énergie de sortie typique de 60 µJ,
- un second CPA 6 Saphir Titane délivrant une puissance crête comprise typiquement entre 100 TW et 30 PW selon le nombre d'amplificateurs de ce CPA.

De nombreuses variantes sont possibles :
- on peut remplacer le BaF2 par du CaF2 ou du SrF2 ou du CaBaF2, ou du CaSrF2 ou du diamant ou du LiF ou du YAG ou tout autre matériau à susceptibilité non linéaire du 3è ordre apte à générer une onde à polarisation croisée,
- les CPA peuvent être remplacés par des OPCPA ou on peut avoir une configuration hybride (OPCPA puis CPA),
- pour un CPA, le milieu amplificateur peut être du Saphir dopé Titane, du verre (ou un mélange) de verres dopé(s) Néodyme ou Ytterbium, du verre ou des cristaux dopés Ytterbium,
- le filtre 5 peut être un filtre XPW HE,
- on peut envisager une configuration avec 3 filtres XPW (2 filtres XPW HE puis 1 filtre XPW par exemple) insérés entre les 2 étages d'amplification à dérive de fréquence, avec un compensateur de dispersion après chacun des 2 premiers filtres XPW ; dans ce cas, on peut envisager une augmentation du contraste de 10 à 12 ordres de grandeur compatible d'une puissance crête ExaWatt,
- on peut envisager une configuration à 3 étages d'amplification à dérive de fréquence (CPA ou OPCPA) comme montré figure 3, avec un ou deux filtres XPW (ou XPW HE) entre deux étages d'amplification (entre le premier 2 et celui du milieu 8, ou entre celui du milieu 8 et le dernier 6 ; dans l'exemple de la figure, il y a deux filtres 3, 7 entre les étages d'amplification 2 et 8), avec un compensateur de dispersion après chacun des premiers filtres XPW, sachant que ce 3è étage d'amplification 8 peut jouer, au travers de son compresseur, le rôle d'un compensateur de dispersion et ainsi en remplacer un. Lorsque la chaîne laser comporte N filtres (N≥ 2 et incluant le premier filtre), il y a un compensateur de dispersion en sortie des N-1 premiers filtres soit N-1 compensateurs.

L'invention peut avoir un autre avantage qui est celui d'une augmentation de l'élargissement spectral inhérent à la technologie XPW. En effet, un étage XPW produit un élargissement du spectre d'un facteur √3 (et donc une réduction de la durée de l'impulsion d'autant) car le phénomène non-linéaire est dépendant du cube de l'intensité. La mise en oeuvre de 2 étages XPW est donc de nature à produire un élargissement du spectre d'un facteur 3. Cette réduction de la durée de chaque impulsion permet de réduire l'énergie de pompage. On utilise alors de préférence, des étages d'amplification à dérive de fréquence de type CPA.

## Revendications

1. Source laser (100) apte à émettre des impulsions d'énergie supérieure ou égale à 100 TéraWatt, constituée d'une chaîne laser qui comprend en cascade :
- un oscillateur laser à état solide (1),
- un premier étage d'amplification (2) à dérive de fréquence, et
- un dernier étage d'amplification (6) à dérive de fréquence, ces premier et dernier étages d'amplification comportant chacun en cascade, un étireur, une chaîne amplificatrice et un compresseur,
- un premier filtre désigné filtre (3) non linéaire à polarisation croisée, à un cristal ou deux cristaux non linéaire(s) et à susceptibilité optique non linéaire du 3è ordre, apte à générer une onde à polarisation croisée, et dans lequel ledit cristal ou lesdits cristaux est (sont) placé(s) entre deux polariseurs,
**caractérisée en ce que** le premier filtre est inséré entre le premier et le dernier étage d'amplification, et **en ce que** la chaîne laser comprend :
- entre le premier (2) et le dernier (6) étage d'amplification, au moins un autre filtre (5, 7) non linéaire à polarisation croisée, soit N filtres dans la chaîne avec N≥ 2 et
- N-1 compensateur(s) de dispersion (4), (respectivement) placé(s) en sortie du (ou des) premier(s) filtres (3).

2. Source laser selon la revendication précédente, **caractérisée en ce que** la chaîne laser comprend un troisième étage (8) d'amplification à dérive de fréquence inséré entre deux filtres non linéaires à polarisation croisée, ce troisième étage d'amplification comportant en cascade un étireur, une chaîne amplificatrice et un compresseur, ce compresseur étant aussi un compensateur de dispersion.

3. Source laser selon l'une des revendications précédentes, **caractérisée en ce qu'**au moins un compensateur de dispersion est un compresseur à miroirs à dispersion contrôlée.

4. Source laser selon l'une des revendications précédentes, **caractérisée en ce qu'**un (ou plusieurs) étage(s) d'amplification est un amplificateur CPA ou un OPCPA.

5. Source laser selon la revendication précédente, **caractérisée en ce qu'**un amplificateur CPA a un milieu amplificateur qui est du Saphir dopé Titane ou du verre ou un mélange de verres dopés Néodyme ou Ytterbium ou des cristaux dopés Ytterbium.

6. Source laser selon l'une des revendications précédentes, **caractérisée en ce que** le cristal non linéaire est un cristal de BaF2.

## Patentansprüche

1. Laserquelle (100), die Energieimpulse von gleich oder mehr als 100 Terawatt emittieren kann, gebildet von einer Laserkette, die in Kaskade Folgendes umfasst:
- einen Halbleiterlaser-Oszillator (1);
- eine erste Verstärkungsstufe (2) mit Frequenzverschiebung; und
- eine letzte Verstärkungsstufe (6) mit Frequenzverschiebung, wobei die erste und die letzte Verstärkungsstufe jeweils in Kaskade einen Strecker, eine Verstärkungskette und einen Kompressor umfassen;
- ein erstes Filter (3), nichtlineares Kreuzpolarisationsfilter genannt, mit einem oder zwei nichtlinearen Kristall(en) und mit einer nichtlinearen optischen Suszeptibilität dritter Ordnung, das eine kreuzpolarisierte Welle erzeugen kann, wobei der/die Kristall(e) zwischen zwei Polarisatoren platziert ist/sind,
**dadurch gekennzeichnet, dass** das erste Filter zwischen der ersten und der zweiten Endverstärkungsstufe eingefügt ist, und dadurch, dass die Laserkette Folgendes umfasst:
- wenigstens ein weiteres nichtlineares Kreuzpolarisationsfilter (5, 7) zwischen der ersten (2) und der letzten (6) Verstärkungsstufe, nämlich N Filter in der Kette, wobei N ≥ 2 ist; und
- N-1 Dispersionskompensator(en) (4), (jeweils) am Ausgang der ein oder mehreren ersten Filter (3) platziert.

2. Laserquelle nach einem vorherigen Anspruch, **dadurch gekennzeichnet, dass** die Laserkette eine dritte Verstärkungsstufe (8) mit Frequenzverschiebung umfasst, die zwischen zwei nichtlineare Kreuzpolausationsfilter eingefügt ist, wobei die dritte Verstärkungsstufe in Kaskade einen Strecker, eine Verstärkungskette und einen Kompressor umfasst, wobei der Kompressor auch ein Dispersionskompensator ist.

3. Laserquelle nach einem der vorherigen Ansprüche, **dadurch gekennzeichnet, dass** wenigstens ein Dispersionskompensator ein gesteuerter Dispersionsspiegelkompressor ist.

4. Laserquelle nach einem der vorherigen Ansprüche, **dadurch gekennzeichnet, dass** eine (oder mehrere) Verstärkungsstufe(n) ein CPA- oder ein OPCPA-Verstärker ist/sind.

5. Laserquelle nach dem vorherigen Anspruch, **dadurch gekennzeichnet, dass** ein CPA-Verstärker ein Verstärkungsmedium hat, das titandotierter Saphir oder Glas oder ein Gemisch aus Neodym- oder Ytterbium-dotierten Gläsern oder von Ytterbium-dotierten Kristallen ist.

6. Laserquelle nach einem der vorherigen Ansprüche, **dadurch gekennzeichnet, dass** der nichtlineare Kristall ein BaF2-Kristall ist.

## Claims

1. A laser source (100) capable of emitting energy pulses of more than or equal to 100 terawatts, made up of a laser chain that in a cascade-like manner comprises:
- a solid-state laser oscillator (1);
- a first amplification stage (2) with frequency shift; and
- a final amplification stage (6) with frequency shift, said first and second amplification stages each comprising a stretcher, an amplifying chain and a compressor in a cascade-like manner;
- a first filter (3), called non-linear cross polarisation filter, with one non-linear crystal or two non-linear crystals and having a third order non-linear optical susceptibility, capable of generating a cross polarised wave, and wherein said crystal or said crystals is/are placed between two polarisers,
**characterised in that** said first filter is inserted between said first and said final amplification stage, and **in that** said laser chain comprises:
- at least one other non-linear cross polarisation filter (5, 7) between said first (2) and said final (6) amplification stage, that is N filters in the chain with N ≥ 2; and
- N-1 dispersion compensator(s) (4), (respectively) placed at the output of the one or more first filters (3).

2. The laser source according to the preceding claim, **characterised in that** said laser chain comprises a third amplification stage (8) with frequency shift inserted between two non-linear cross polarisation filters, said third amplification stage comprising a stretcher, an amplifying chain and a compressor in a cascade-like manner, said compressor also being a dispersion compensator.

3. The laser source according to any one of the preceding claims, **characterised in that** at least one dispersion compensator is a controlled dispersion mirror compressor.

4. The laser source according to any one of the preceding claims, **characterised in that** one or more amplification stages is/are a CPA or an OPCPA amplifier.

5. The laser source according to the preceding claim, **characterised in that** a CPA amplifier has an amplifying medium that is titanium doped sapphire or glass or a mixture of neodyme or ytterbium doped glasses or of ytterbium doped crystals.

6. The laser source according to any one of the preceding claims, **characterised in that** said non-linear crystal is a BaF2 crystal.
